Europäisches Patentamt

(19) European Patent Office

Office européen des brevets

(11) Numéro de publication: **0 013 340**

**A1**

(12) **DEMANDE DE BREVET EUROPEEN**

(21) Numéro de dépôt: **79104871.3**

(22) Date de dépôt: **04.12.79**

(51) Int. Cl.³: **H 01 L 29/86**
**H 01 L 21/265**

(30) Priorité: **28.12.78 FR 7837092**

(43) Date de publication de la demande:
**23.07.80 Bulletin 80/15**

(84) Etats Contractants Désignés:
**DE FR GB**

(71) Demandeur: **International Business Machines Corporation**

**Armonk, N.Y. 10504(US)**

(72) Inventeur: **Nuez, Jean-Paul**
**34 Avenue des Coquelicots**
**F-91540 Mennecy(FR)**

(72) Inventeur: **Lebesnerais, Gérard**
**9 Rue des Près Saint Germain S/Ecole**
**F-77930 Perthes en Gatinais(FR)**

(74) Mandataire: **Klein, Daniel**
**COMPAGNIE IBM FRANCE Département de Propriété Industrielle**
**F-06610 La Gaude(FR)**

(54) **Résistance à tension de claquage améliorée obtenue par une double implantation ionique dans un substrat semi-conducteur et son procédé de fabrication.**

㊼ Le procédé est essentiellement caractérisé en ce qu'il comporte deux étapes d'implantation successives d'ions bore, dans un substrat typiquement de silicium de type N; la première est à forte dose et à faible énergie ($10^{12}$ à $10^{15}$ at/cm² - 20 à 120 KeV) et la seconde est à faible dose et à forte énergie ($10^{11}$ à $10^{14}$ at/cm² - 120 à 400 KeV). Le rapport préféré des doses est d'environ 10. Les résistances obtenues sont précises, elles ont en fait un faible TCR (coefficient de température) et une tension de claquage élevée; elles trouvent application notamment dans les circuits analogiques et les dispositifs de visualisation, à forte densité d'intégration.

FIG. 6

EP 0 013 340 A1

1

### RESISTANCE A TENSION DE CLAQUAGE AMELIOREE OBTENUE PAR UNE DOUBLE IMPLANTATION IONIQUE DANS UN SUBSTRAT SEMI-CONDUCTEUR ET SON PROCEDE DE FABRICATION

## Description

### Domaine de l'invention

La présente invention concerne une structure de résistance implantée pour des dispositifs intégrés à semi-conducteurs et son procédé de fabrication; elle concerne plus particulièrement une résistance formée par une double implantation ionique et présentant une tension de claquage élevée.

### Etat de la technique

Les résistances intégrées implantées sont généralement formées par l'implantation d'ions d'un premier type de conductivité dans un substrat semi-conducteur monocristallin d'un type de conductivité opposé. Cette étape forme une région qui est séparée du substrat par une jonction.

Une jonction est donc la surface (supposée en première approximation plane) qui sépare dans un monocristal de semi-conducteur, une région d'un premier type de conductivité, d'une région contiguë du type de conductivité opposé. Ces jonctions semi-conductrices ont des propriétés extrêmement importantes et sont à la base du développement considérable que connaît aujourd'hui l'industrie des circuits intégrés à semi-conducteurs.

Dans une réalisation classique, un corps monocristallin de silicium de type P est recouvert par une couche

2

épitaxiale de type N. Dans cette couche on forme, par diffusion ou par implantation ionique une région de type P, généralement à travers une couche de masquage en bioxyde de silicium, formée selon une configuration désirée, sur la couche épitaxiale.

Cette région de type P forme avec la couche épitaxiale, une jonction qui peut être utilisée à de multiples autres usages: diode, jonction collecteur-base d'un transistor bipolaire planar, région drain d'un transistor à effet de champ à grille isolée, etc. .

Dans tous les cas, quelque soit l'utilisation faite de la jonction, un paramètre capital, notamment dans les applications aux circuits intégrés analogiques, est la tension de claquage de la jonction quand cette dernière est polarisée en inverse. Ce claquage est un phénomène électrique, généralement non destructif. Il est parfois utile (diodes Zener) mais le plus souvent il est une cause de limitation dans l'utilisation du dispositif (ou même de rejet), dans certaines applications qui requièrent une tension de claquage élevée.

La tension de claquage d'une jonction $V_B$, dépend de nombreux facteurs dont les dopages des régions contiguës qui sont déterminants pour le champ électrique dans la zone de charge d'espace. Physiquement, le claquage résulte de l'arrachement d'électrons de valence aux atomes du cristal par les porteurs accélérés par le champ électrique. Les électrons ainsi arrachés et accélérés par le champ électrique, participent à leur tour, à l'arrachement d'autres électrons produisant ainsi un effet d'avalanche qui augmente rapidement le courant inverse de la jonction.

3

Quand on forme classiquement une jonction par le procédé de diffusion à travers une ouverture pratiquée dans la couche de masquage en bioxyde de silicium, après redistribution du dopant, on trouve évidemment une jonction plane formée sous la fenêtre à la distance $x_j$ de la surface ($x_j$ est la profondeur de la jonction diffusée), mais le dopant pénètre également sous la couche de masquage sur une distance égale à $0,8 x_j$, de sorte que sur les bords la jonction est à peu près cylindrique, tandis qu'aux coins du rectangle elle est à peu près sphérique. C'est l'effet bien connu dans la technique sous le nom de diffusion latérale. Le champ électrique dans la zone de charges d'espace des parties cylindriques ou sphériques, de la jonction est plus grand que dans la partie plane, ainsi le phénomène d'avalanche se produit pour des tensions plus faibles, dans les premières que dans la seconde. La courbure de la jonction diminue ainsi la tension de claquage par avalanche. Ce phénomène très important a été étudié par Gibbons et al, Effects of Junction Curvatures on Break-Down Voltages in Semiconductors, revue Solid State Electronics, 1966, Vol. 9, pages 831 à 845. Les auteurs ont publié des tableaux de valeurs de tensions de claquage, pour des jonctions planes, cylindriques et sphériques, pour les deux types de jonctions: abrupte et graduelle, pour différents matériaux Ge, Si et GaAs.

Le problème est identique dans le cas d'une jonction réalisée par implantation ionique quand les bords de la fenêtre de la couche de masquage sont inclinés, ce qui est le cas général avec les étapes de décapage classiques. Les enseignements que l'on peut tirer des travaux mentionnés ci-dessus, sont donc directement applicables aux résistances implantées.

4

Le problème de la tension de claquage dans les résistances intégrées est particulièrement important. D'abord bien sûr dans les applications à courants forts, où des tensions de claquage supérieures à 2000V sont recherchées, mais également dans les applications à courants faibles (circuits logiques, de mémoire, analogiques, ...).

Dans les applications à courants forts, une technique classique consiste à utiliser une électrode d'affaiblissement de champ; un exemple est décrit dans le brevet français No. 71 26688 déposé le 21 juillet 1971 par la Société Fairchild. Cette technique revient en fait à déformer la partie de la région d'appauvrissement qui se trouve dans le substrat sans apporter de modification à la forme de la jonction métallurgique.

Cette solution présente l'inconvénient de consommer de la surface de silicium et donc de réduire la densité d'intégration.

Une autre solution, qui consiste à modifier directement la forme de la jonction est décrite dans le brevet français No. 74 22656 déposé le 28 juin 1974 par la Société Signetics. Dans ce brevet qui se rapporte à une résistance implantée, on utilise une couche de masquage qui présente une ouverture munie d'un décrochement, ce qui permet d'obtenir une jonction de forme irrégulière, par ailleurs classique dans le domaine de la fabrication des transistors bipolaires formés par implantation ionique.

Cette solution est relativement simple, elle présente cependant l'inconvénient de nécessiter obligatoirement la réoxydation du silicium exposé dans l'ouverture de la couche de masquage de $SiO_2$, de nécessiter la formation d'une nouvelle couche de masquage en matériau photorésistant (afin d'obtenir la configuration de masquage désirée avec le décrochement mentionné ci-dessus) et enfin ce type de résistance ne permet pas d'optimiser à la fois le coefficient de température de la résistance (TCR) et sa tension de claquage $V_B$.

Présentation de l'invention

En conséquence, un premier objet de l'invention est de fournir un procédé de fabrication de résistances implantées ne nécessitant pas d'étapes de masquage supplémentaire.

Un autre objet de l'invention est de fournir un procédé de fabrication de résistances implantées qui ne demande pas une surface de substrat additionnelle, afin d'être compatible avec les fortes densités d'intégration que requièrent les technologies modernes.

Encore un autre objet de la présente invention est de fournir un procédé de fabrication de résistances implantées dans lequel le coefficient de température et la tension de claquage peuvent être ajustés indépendamment l'un de l'autre.

La présente invention concerne un procédé de fabrication d'une résistance implantée, de grande précision, à faible TCR et à tension de claquage améliorée dans un substrat semi-conducteur d'un premier type de conductivité, caractérisé en ce qu'il comporte les étapes de:

. première implantation d'impuretés d'un second type de conductivité opposé audit premier type dans une

6

région déterminée du substrat, d'une dose principale comprise entre environ $10^{12}$ et $10^{15}$ at/cm$^2$, à faible énergie comprise entre environ 20 et 120 KeV pour définir la valeur désirée de la résistance et assurer un faible TCR,

. seconde implantation d'impuretés dudit second type dans cette région, d'une dose secondaire comprise entre environ $10^{11}$ et $10^{14}$ at/cm$^2$, inférieure à la dose principale, et à forte énergie comprise entre environ 120 et 400 KeV, pour assurer une tension de claquage améliorée, sans modifier sensiblement pour autant la valeur désirée de la résistance, et

. recuit du substrat.

Dans une réalisation préférée, ce rapport des doses principale et secondaire est d'au moins 10.

La présente invention concerne également une structure de résistance implantée, ayant une valeur précise, un faible TCR et une tension de claquage élevée, du genre comportant un substrat d'un premier type de conductivité, une région formant lit de la résistance d'un second type de conductivité opposé audit premier type disposée dans le substrat; cette structure étant caractérisée en ce que cette région est composée d'une première partie en surface, peu profonde et fortement dopée, et d'une seconde partie englobant la première, plus faiblement dopée et plus profonde, cette dernière définissant la jonction électrique entre la région et le substrat semi-conducteur.

La présente invention concerne plus particulièrement une telle structure de résistance, dans laquelle ladite première partie est réalisée par une première implantation ionique d'une impureté du second type de conductivité, à faible énergie comprise entre environ 20 et 120 KeV et à forte dose, comprise entre environ $10^{12}$ et $10^{15}$ at/cm$^2$ et ladite seconde partie est réalisée par une seconde implantation ionique d'une impureté dudit second type de conductivité, à forte énergie comprise entre 120 et 400 KeV et à plus faible dose comprise entre environ $10^{11}$ et $10^{14}$ at/cm$^2$.

Dans une réalisation préférée le rapport des doses sera choisi égal à au moins 10.

D'autres objets, caractéristiques et avantages de la présente invention ressortiront mieux de l'exposé qui suit, fait en référence aux dessins annexés à ce texte qui représentent un mode de réalisation préféré de celle-ci.

Brève description des figures

La figure 1 représente une vue en coupe d'une jonction PN classique de la technique antérieure formée par une étape de diffusion ou d'implantation ionique.

La figure 2 représente le profil de la concentration (C) en fonction de la profondeur (x) le long de la ligne 1-1' de la figure 1.

La figure 3 représente une vue en coupe d'une jonction PN formée par une double implantation ionique conforme à l'invention.

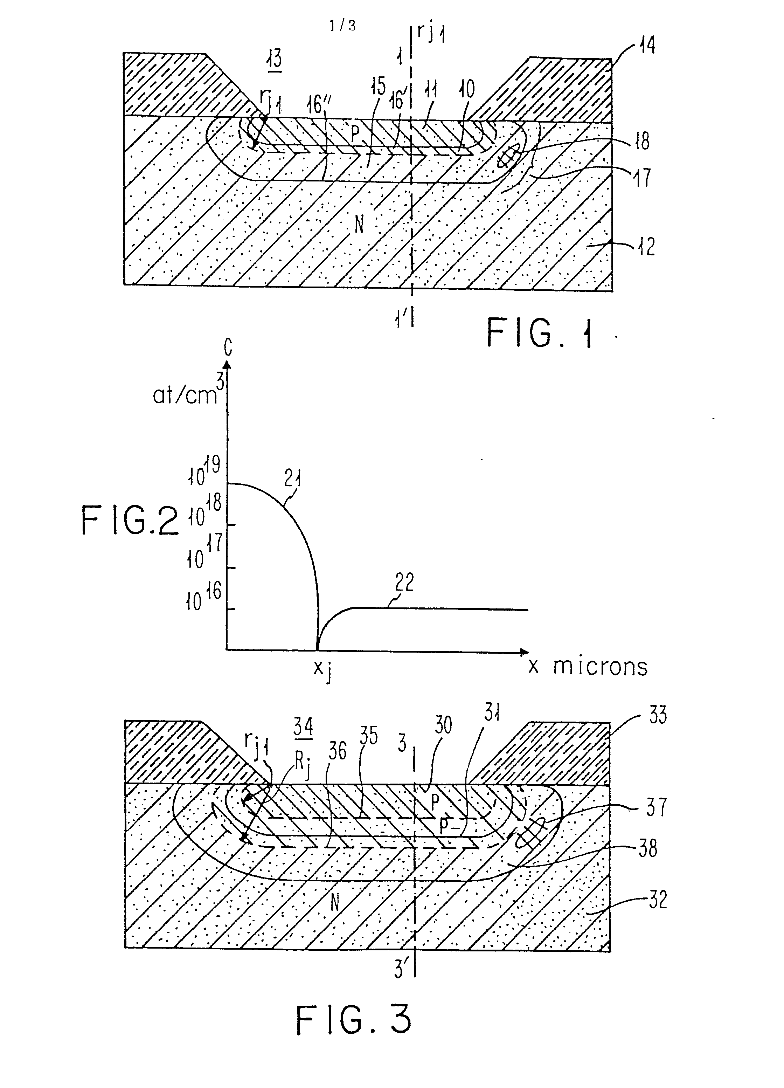

La figure 4 représente les profils de la concentration résultante et des profils de concentration des deux

8

implantations ioniques, le long de la ligne 3-3' de la figure 3.

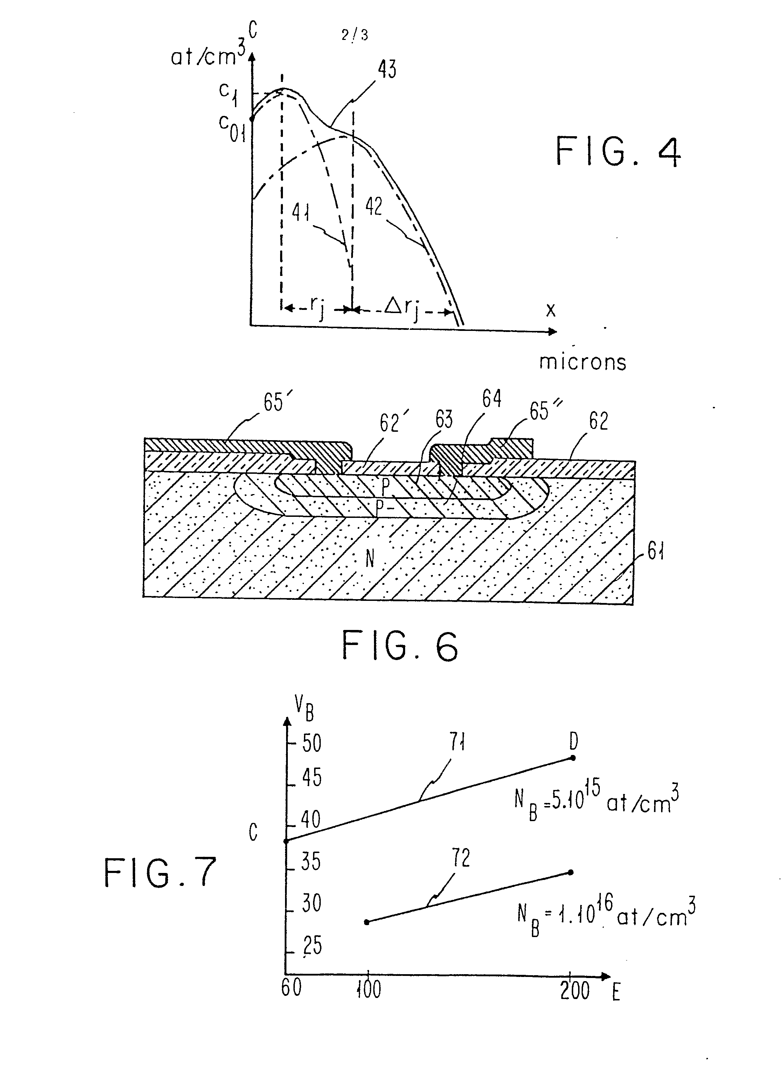

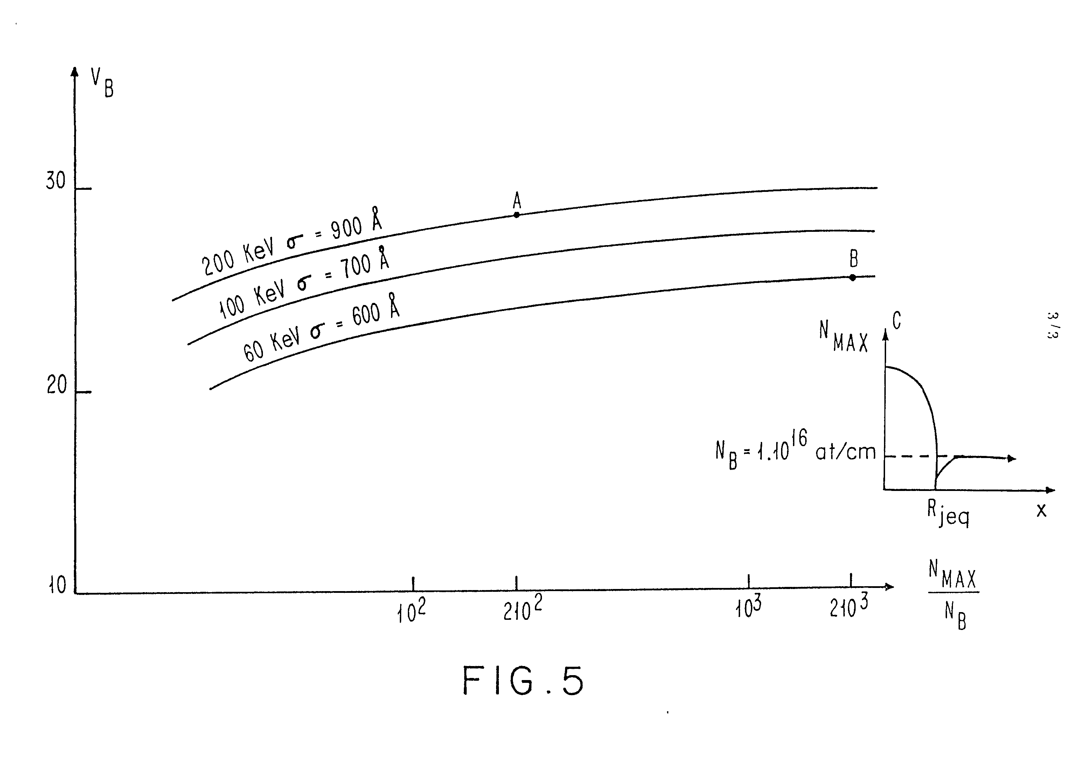

La figure 5 représente un réseau d'abaques déterminées par le calcul qui donnent la tension de claquage $V_B$ d'une jonction implantée en fonction du rapport $\dfrac{N_{MAX}}{N_B}$ pour différentes valeurs de l'énergie d'implantation.

La figure 6 représente une vue en coupe d'une résistance implantée conforme à l'invention une fois terminée.

La figure 7 représente la variation de la tension de claquage $V_B$ en fonction de l'énergie d'implantation pour des paramètres d'implantation déterminés.

Description d'un mode de réalisation

La figure 1 montre une structure classique comportant une jonction PN 10 formée entre une région de type P 11 et une couche épitaxiale de type N 12. Cette couche recouvre généralement un support ou substrat semi-conducteur (non représenté sur la figure).

La région 11 peut être formée par exemple par implantation d'ions de bore à travers une ouverture pratiquée dans la couche de masquage 14 en dioxyde de silicium. Quand la jonction 10 est polarisée en inverse, il se développe de chaque côté une région d'appauvrissement ou de charge d'espace 15 dont les frontières sont indiquées par les lignes 16' et 16". Cette région d'appauvrissement qui est une région appauvrie en porteurs minoritaires et majoritaires mobiles, comporte un champ électrique induit par les charges fixes de

9

cette région. Ces charges sont positives dans la portion de la région d'appauvrissement comprise dans la
couche épitaxiale 12 et négatives dans la portion
comprise dans la région 11 de type P. L'intensité de ce
champ électrique croît avec la tension inverse appliquée. La région d'appauvrissement contient une partie
incurvée 17, dans laquelle le champ électrique représenté par les lignes de flux 18 devient intense quand
la tension inverse s'accroît. Le claquage de la jonction se produit généralement, dans cette région incurvée, le rayon de courbure de cette partie incurvée
($r_{j1}$) est donc déterminant pour la valeur de la tension
de claquage.

Sur la figure 2 on a représenté les courbes 21 et 22
qui montrent respectivement les concentrations des
régions 11 et 12 en fonction de la profondeur x
le long de la ligne 1-1'.

Avec la recherche d'une miniaturisation encore plus
poussée et l'accroissement des vitesses, il y a actuellement une nette tendance, à mettre en oeuvre des
couches épitaxiales de plus en plus fines (épaisseur de
l'ordre d'un micron ou même moins) qui impliquent donc
des régions résistives très fines. Le présent procédé
de la présente invention est compatible avec ces technologies modernes.

Bien que l'invention soit d'application relativement
générale, en tant que décrivant une jonction perfectio.:née, elle sera décrite ci-après dans le cas d'une
résistance implantée, très fine, où le problème de la
tension de claquage est particulièrement aïgu.

10

D'une façon générale, dans le cas de la réalisation d'une telle résistance très fine, formée par l'implantation d'ions de type P dans une couche épitaxiale de type N, le concepteur de circuit qui souhaite avoir un coefficient de température (TCR) minimal, doit utiliser une implantation à basse énergie, car de ce fait la concentration de surface en dopant est plus forte et l'on sait que le TCR est alors plus faible. Ce procédé classique qui permet l'obtention de résistances très précises de forte valeur, et à TCR faible présente alors l'inconvénient décrit plus haut, à savoir que la couche implantée fine présente un rayon de courbure faible, et donc une tension de claquage médiocre.

L'idée fondamentale de la présente invention consiste à fournir un procédé qui garde la même résistivité souhaitée mais qui assure en outre une meilleure tension de claquage parce que basé sur une double implantation ionique, il permet d'ajuster de façon séparée, les paramètres: valeur de la résistance et TCR d'une part et la tension de claquage, d'autre part.

Avec une étape de masquage supplémentaire, il permet d'obtenir des jonctions présentant des tensions de claquage différentes sur un même substrat semi-conducteur. Cette réalisation est particulièrement avantageuse, dans certaines applications aux circuits analogiques pour protéger par exemple un amplificateur contre les sur-tensions. Le claquage peut se produire au niveau de la résistance et non pas dans le composant protégé.

Sur la figure 3, on a représenté une jonction qui est réalisée par une double implantation d'ions de type P,

11

avec des doses et des énergies différentes, qui forme les régions 30 et 31 respectivement de type P et $P^-$, dans la couche épitaxiale de type N 32.

De façon classique on réalise une couche de masquage en $SiO_2$ 33 présentant une ouverture 34 à l'emplacement désiré. On réalise une première implantation ionique avec des ions de type P, tels que des ions bore, à forte dose comprise entre environ $10^{12}$ et $10^{15}$ at/cm$^2$ et à faible énergie, comprise entre environ 20 et 120 KeV, qui forme la région 30. Puis, en gardant la même couche de masquage, on procède à une seconde implantation ionique avec des ions de type P, par exemple également des ions bore, à plus faible dose comprise entre environ $10^{11}$ et $10^{14}$ at/cm$^2$ et à forte énergie comprise entre environ 120 et 400 KeV, pour former la région 31.

Le rapport entre les doses des première et seconde implantations étant supérieur à 2, et de l'ordre de 10 de préférence.

L'avantage de cette deuxième implantation ionique, réalisée à plus grande profondeur est que le rayon de courbure $r_{j1}$ de la jonction 35 est supérieur au rayon $r_{j1}$ de la jonction 36. On bénéficie ainsi d'une meilleure tenue au claquage. En effet, les lignes de flux électriques (représentées en 37) contenues à l'intérieur de la région d'appauvrissement 38 sont approximativement parallèles, ce qui montre qu'il n'y a plus de région particulièrement sensible à la tension inverse. Il en résulte finalement que le claquage de la jonction se produit à une tension plus élevée.

12

La première implantation définit les paramètres de la région 30 tandis que la deuxième définit les paramètres de la région 31 sans altérer ceux de la région 30.

On aboutit à une région résultante du type P formée de deux parties 30 et 31, qui peut servir de lit à une résistance. Dans ce cas, la valeur effective de la résistance est donnée par la résistance parallèle des parties profondes et moins profondes, c'est-à-dire pratiquement la valeur de la résistance de région 30 plus dopée.

Ainsi, la première implantation détermine la valeur de la résistance de surface ($R_S$) et le TCR, et la seconde implantation définit la position de la jonction résultante. La région 31 contient la couche d'appauvrissement de la jonction résultante et détermine la tension de claquage.

Sur la figure 4 on a représenté les profils de concentratrion 41 et 42 des deux implantations ioniques $I_1$ et $I_2$. La courbe 43 représente le profil de concentration résultant. La valeur de la résistance étant déterminée par le circuit électrique choisi, les conditions opératoires de la première implantation sont donc déterminées (on pourra simplement les ajuster en fonction du TCR désiré). La deuxième implantation détermine la tension de claquage $V_B$. Il peut être utile de connaître les différentes valeurs de $V_B$ que l'on peut obtenir en fonction des paramètres d'implantation (espèce chimique, dose, énergie d'implantation). Un réseau d'abaques serait donc souhaitable au concepteur de circuit pour faciliter son choix. Ce réseau peut être établi à l'aide d'un modèle mathématique simplifié. On va chercher quels sont les paramètres de base ($N_{MAX}$, $R_{jeq}$) d'un

13

profil Gaussien équivalent à celui des deux implantations $I_1$ et $I_2$ (figure 4). Pour cela on fait les approximations suivantes; pour $I_1$ on prend comme valeur de concentration de surface, la concentration maximale $N_{MAX} = C_1$ (au lieu de $C_{01}$). Egalement on prend la valeur $R_{jeq} = r_j + \Delta r_j$. Le profil équivalent est montré sur la figure 5, il ne correspond pas parfaitement, bien sûr avec le profil exact représenté en 43 sur la figure 4. Sur la figure 5 on a représenté les tensions de claquage de cette jonction, équivalente à celle qui serait obtenue par une seule implantation ionique, en fonction du rapport de la concentration maximale $N_{MAX}$ sur la concentration de la couche épitaxiale $N_B$, pour des énergies d'implantation comprises entre 20 et 200 KeV. Les écarts types $\sigma$ de la gaussienne type sont également indiqués. La tension de claquage est donc une fonction de $N_{MAX}$, $N_B$ et $R_{jeq}$. L'utilisation pratique de ces abaques va être donnée ci-après dans la description détaillée de la fabrication d'une résistance conforme à l'invention (figure 6).

On part d'un substrat de silicium monocristallin, non représenté, de type P (orientation <100>, résistivité 10-20 $\Omega$.cm) qui est recouvert par une couche épitaxiale 61 de type N (résistivité 0,5 $\Omega$.cm, épaisseur 4 microns, concentration en impuretés $N_B = 1,0 \times 10^{16}$ at/cm$^3$). On oxyde cette tranche dans une atmosphère humide pendant un temps suffisant (de 10 à 30mn) pour faire croître une couche de masquage de 4000Å de $SiO_2$, 62. Après une étape de lithographie classique, on forme une ouverture, selon une configuration déterminée, dans cette couche de masquage. La première implantation peu profonde, définit la valeur de la résistance et le TCR. Par exemple, pour obtenir une résistance de 600 $\Omega/\square$, on implante des ions bore, avec une énergie de 60 KeV et

14

une dose principale de $1,4 \times 10^{14}$ at/cm$^2$. La région obtenue 63 constitue le lit de la résistance; elle présente un $R_S$ de 660 $\Omega/\square$ et un TCR de 1200 ppm/°C. La seconde implantation définit la tension de claquage de la résistance, elle est effectuée à plus faible dose, et à forte énergie pour définir la région profonde 64. Elle est effectuée à travers la même ouverture pratiquée dans la couche de SiO$_2$. Le concepteur de circuit peut utiliser les abaques de la figure 5 pour guider son choix. Pour obtenir une tension de claquage d'environ 28V, il peut choisir une énergie d'implantation de 200 KeV et le point A qui correspond à un rapport

$$\frac{N_{MAX}}{N_B} = 2.10^2 \text{ avec } N_B = 1,0 \times 10^{16} \text{ at/cm}^3 \text{ et } \sigma = 900 \text{ Å}.$$

La relation $N_{MAX} = \dfrac{dose}{\sigma \sqrt{2\pi}}$ permet de déterminer la dose secondaire qui est de $1,4 \times 10^{13}$ at/cm$^2$. Le rapport des doses est bien de 10. L'ordre des deux implantations importe peu. Cette structure a été réalisée, la tension de claquage mesurée était de 29V.

Ces implantations sont suivies par un recuit thermique à 1000°C pendant 30 minutes. Après recuit dans une atmosphère d'oxygène, pendant lequel une couche de SiO$_2$ 62' est développée sur le lit de la résistance, une nouvelle étape de lithographie permet d'ouvrir les deux ouvertures pour la formation des contacts. Une couche d'aluminium est alors déposée par évaporation sous vide, puis délimitée selon la configuration désirée pour fournir les conducteurs 65' et 65". La résistance est ainsi achevée.

Il est évident que les figures ne représentent qu'une

15

partie du support ou substrat semi-conducteur et qu'un grand nombre de résistances implantées conformes à l'invention peuvent être formées simultanément. En outre cette résistance à double implantation fait généralement partie d'un circuit intégré comprenant également des dispositifs actifs et passifs, tels que des transistors, des diodes, des capacités, etc. .

Si on avait gardé seulement la région 63 peu profonde, comme dans l'art antérieur, les conditions d'implantation précisées plus haut auraient conduit au point B, et la résistance n'aurait eu qu'une tension de claquage de l'ordre de 23V.

La figure 7 met particulièrement en évidence les variations de la tension de claquage $V_B$ en fonction de l'énergie de la seconde implantation. Le point C de la droite 71, représente les paramètres d'implantation suivants 60 KeV, dose principale: $1 \times 10^{14}$ at/cm$^2$, $N_B = 5,0 \times 10^{15}$ at/cm$^3$, la jonction obtenue présente un $V_B = 38V$. Le point D défini par les paramètres suivants: 200 KeV, $1 \times 10^{13}$ at/cm$^2$, $N_B = 5,0 \times 10^{15}$ at/cm$^3$, définit une jonction ayant un $V_B$ de 48V. Le procédé de la présente invention permet donc une amélioration de la tension de claquage de cette résistance d'environ 25%. On a également représenté en 72 une courbe similaire pour $N_B = 1 \times 10^{16}$ at/cm$^3$.

L'augmentation de profondeur de la jonction résultante (6000 Å) n'est pas un problème, les épitaxies les plus fines se trouvent actuellement aux environs de 1 micron.

Ainsi avec la tendance actuelle vers une miniaturisation de plus en plus poussée des circuits intégrés à semi-conducteurs, l'implantation ionique prend une

16

importance croissante et les dispositifs sont de plus en plus minces. La limitation qui en résultait, étant les relativement faibles tensions de claquage des jonctions. La présente invention permet de remédier à cet inconvénient, en améliorant les tensions de claquage des jonctions, sans nuire pour autant à leurs performances. Ces jonctions ainsi améliorées peuvent être utilisées dans de nombreux dispositifs passifs (résistances) ou actifs (diodes, et transistors) notamment dans le cas des applications aux circuits analogiques, dispositifs de visualisation, etc. .

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

17

REVENDICATIONS

1.- Structure de résistance implantée ayant une valeur précise, un faible TCR et une tension de claquage élevée du genre comportant, un substrat d'un premier type de conductivité, une région formant lit de la résistance d'un second type de conductivité opposé audit premier type disposée dans le substrat, caractérisée en ce que cette région est composée d'une première partie en surface, peu profonde et fortement dopée, et d'une seconde partie englobant la première, plus faiblement dopée et plus profonde, cette dernière définissant la jonction électrique entre la région et le substrat semi-conducteur.

2.- Structure de résistance selon la revendication 1 caractérisée en ce que ladite première partie est réalisée par une première implantation ionique d'une impureté du second type de conductivité, à faible énergie comprise entre environ 20 et 120 KeV et à forte dose, comprise entre environ $10^{12}$ et $10^{15}$ at/cm$^2$ et ladite seconde partie est réalisée par une seconde implantation ionique d'une impureté dudit second type de conductivité, à forte énergie comprise entre 120 et 400 KeV et à plus faible dose comprise entre environ $10^{11}$ et $10^{14}$ at/cm$^2$.

3.- Structure de résistance selon la revendication 2 caractérisée en ce que le rapport des doses des première et seconde implantations ioniques est d'au moins environ 10.

18

4.- Structure de résistance selon l'une des revendications 1, 2 ou 3, caractérisée en ce que la surface du substrat est recouverte par une couche isolante portant des conducteurs électriques qui la traversent en des points désirés et assurent le contact électrique avec la région résistive.

5.- Procédé de fabrication d'une résistance implantée telle que définie dans la revendication 1, caractérisé en ce qu'il comporte les étapes de:

. première implantation d'une impureté d'un second type de conductivité opposé audit premier type dans une région déterminée du substrat, d'une dose principale comprise entre environ $10^{12}$ et $10^{15}$ at/cm$^2$, à faible énergie comprise entre environ 20 et 120 KeV pour définir la valeur désirée de la résistance et assurer un faible TCR,

. seconde implantation d'une impureté dudit second type dans cette région d'une dose secondaire comprise entre environ $10^{11}$ et $10^{14}$ at/cm$^2$ inférieure à la dose principale, et à forte énergie comprise entre environ 120 et 400 KeV, pour assurer une tension de claquage améliorée, sans modifier sensiblement pour autant la valeur désirée de la résistance, et

. recuit du substrat.

6.- Procédé de fabrication selon la revendication 5 caractérisé en ce que les étapes d'implantation sont effectuées dans l'ordre inverse de celui mentionné.

7.- Procédé de fabrication selon la revendication 5 ou 6 caractérisé en ce que le rapport des doses principale et secondaire est d'au moins 10.

8.- Procédé de fabrication selon la revendication 5, 6 ou 7, caractérisé en ce que l'impureté choisie pour les première et seconde implantations ioniques est le bore.

9.- Procédé de fabrication selon la revendication 5, 6, 7 ou 8 caractérisé en ce que l'étape de recuit s'effectue à une température comprise entre 900° et 1050° pendant un temps compris entre 1 minute et plusieurs heures.

10.- Procédé de fabrication selon la revendication 5, 6 ou 7 caractérisé en ce que les paramètres de la première implantation sont: ions bore, énergie d'implantation 60 KeV, dose 1 x $10^{14}$ at/cm$^2$, ceux de la seconde implantation sont: ions bore, énergie d'implantation 200 KeV, dose: 1 x $10^{13}$ at/cm$^2$, et que le recuit s'effectue à 1000° pendant 30 minutes.

0013340

FIG. 1

FIG.2

FIG.3

FIG. 4

FIG. 6

FIG. 7

FIG.5

001334C

| Catégorie | Citation du document avec indication, en cas de besoin, des parties pertinentes | Revendication concernee | CLASSEMENT DE LA DEMANDE (Int. Cl. ⁴) |
|---|---|---|---|
| | IBM TECHNICAL DISCLOSURE BULLETIN vol. 20, mars 1978, New York, US Z.C. PUTNEY: "Simultaneous formations of high sheet resistance ion-implanted resistors and impurity gettering for bipolar transistors" pages 4011-4012. \* Pages 4011-4012 \* | 1-5,7, 8 | H 01 L 29/86 H 01 L 21/265 |
| | US - A - 4 005 450 (HITACHI) \* Abrégé; colonne 5, ligne 38 - colonne 7, ligne 32; figures 4A-4H \* | 5,6,8 | |
| | US - A - 3 548 269 (SPRAQUE ELECTRIC CY.) \* Abrégé, colonne 3, ligne 41 - colonne 4, ligne 47; revendication 5; figure 4 \* | 1,2,5, 6,8,9 | |
| | DE - A - 1 916 969 (IBM) \* Page 3, alinéas 2-4; page 9, alinéa 3 - page 12, alinéa 4 \* & FR - A - 2 006 332 | 1 | |

**DOCUMENTS CONSIDERES COMME PERTINENTS**

DOMAINES TECHNIQUES RECHERCHES (Int. Cl. )

H 01 L 29/86
H 01 L 21/265

CATEGORIE DES DOCUMENTS CITES

X  particulièrement pertinent
A  arriere-plan technologique
O  divulgation non-ecrite
P  document intercalaire
T  theorie ou principe a la base de l'invention
E  demande faisant interference
D  document cité dans la demande
L  document cite pour d'autres raisons

&  membre de la même famille, document correspondant

Le present rapport de recherche a ete etabli pour toutes les revendications

| Lieu de la recherche | Date d'achevement de la recherche | Examinateur |
|---|---|---|
| La Haye | 24-01-1980 | CHOMENTOWSKI |

OEB Form 1503.1  06.78